# EUROPEAN PATENT SPECIFICATION

(11) **EP 0 279 969 B1**
(45) Date of publication and mention of the grant of the patent: **06.04.1994**
(21) Application number: 87301621.6
(22) Date of filing: 25.02.1987
(51) Int. Cl.: G01K 7/02

(54) **Heat sensitive cable and method of making same**
Wärmeempfindliches Kabel und Verfahren zur Herstellung desselben
Câble thermosensible et procédé pour le réaliser

(43) Date of publication of application: 31.08.1988
(73) Proprietor: Xco International Incorporated, Elgin Illinois 60120 (US)
(72) Inventor: Bayard, C. Davis, Lombard Illinois 60148 (US)
(74) Representative: Griffin, Kenneth David

(56) References cited:
- EP-A- 0 078 675
- DE-A- 3 045 652
- GB-A- 2 059 304
- US-A- 2 665 322
- US-A- 3 408 607
- US-A- 3 845 706

## Description

The present invention relates to heat sensitive devices and, more particularly, to a heat sensitive cable and method of making same.

Heat sensitive cables which are characterised by the use of semiconductive materials having inverse temperature-resistance characteristics in conjunction with dissimilar thermoelectric conductors are now well known in the art. Such cables are particularly suitable where it is desired to monitor the greatest temperature existing along the length of the cable, and are exemplified in connection with a system for measuring and locating temperature conditions of interest in US-A-3,408,607 and US-A-4,324,138. Thermistor cables which are characterised by a core of semiconductive material surrounded by a mass of temperature-resistant electrically-insulating material covered with a protective metallic sheath are also well known in the art.

Despite the clear advantages and many applications for such cables, they have simply not evolved to the point of providing the desired degree of versatility. It has remained to develop a heat sensitive cable capable of generating a measurable and predictable voltage when the entire length of cable is at ambient, eg, 22°C (72°F), wherein the cable is also adapted to provide a change in the temperature representative measurable voltage with an increase in temperature above the prevailing ambient at any location along the cable. If this could be achieved with an electrical insulation having a negative temperature coefficient, the thermoelectric output of the cable or a section thereof would be altered in a predictable fashion.

Moreover, if this could be achieved, the cable location where an increase in temperature takes place could be located electronically. This could be done, for instance, as fully disclosed in US-A-4,324,138. As set forth therein, the applications are virtually limitless.

While the value of heat sensitive cable has long been recognized, it has remained to provide such a cable having the requisite versatility for the many applications to be benefited by use thereof. In fact, despite many prior inventions in this field, as exemplified by US-A-3,408,607 and US-A-3,513,432, the missing link to providing a highly versatile cable has remained. Despite the advantages that will be recognized by those skilled in the art, heat sensitive cable which may not only be utilized to monitor ambient temperature but also may be utilized to monitor for any localised increase above ambient temperature has simply not been available.

In EP-A-0,078,675, there is described a heat sensitive cable comprising a tubular metallic sheath, a mass of compacted insulation material filling the sheath, and a pair of thermoelectric conductors positioned in the insulation material. In US-A-3,845,706, there is described a thermocouple device for measuring the temperature of the hot face of an electric arc furnace. The device comprises a pair of thermoelectric conductors held inside a sleeve by refractory material. One of the conductors is insulated with glass material. DE-A-3,045,652 describes a thermocouple comprising a pair of thermoelectric conductors joined together to form a thermocouple.

US 3 408 607 discloses a cable in which two conductors are maintained in separated relation by densely compacting a mass of semi-conductive material about the conductors. This tends to make the cable inflexible. The cable is shielded and therefore a metallic sheath is required.

It is an object of the present invention to provide a heat sensitive cable having means for generating a temperature representative measurable voltage and which provides the desired degree of versatility.

According to one aspect of this invention, there is provided a heat sensitive cable as defined in claim 1.

With this arrangement, the heat sensitive cable may be utilized not only to monitor ambient temperature but also to monitor for any localised increase in temperature as described further below.

Preferably, the conductor is coated with a solution of manganese nitrate or the surface of the conductor is covered with heat treated manganese dioxide. By so doing, the resulting electrical insulation which is formed on the surface of the conductor has a negative temperature coefficient and will provide the required temperature representative measurable voltage throughout the desired range of temperatures.

Conveniently, one of the conductors is formed of a nickel/chromium alloy and the other of the conductors is formed of a copper/nickel alloy. Preferably, the nickel/chromium alloy comprises approximately 90 per cent nickel and 10 per cent chromium and the copper/nickel alloy comprises approximately 55 per cent copper and 45 per cent nickel.

With regard to the flexible outer jacket, it is preferably formed of a material that may be applied to completely surround the conductors in a fashion applying pressure to hold the conductors in contacting side-by-side relation. In this connection, the material may be of a type adapted to be extruded onto the conductors, or a material of the type adapted to be heat shrunk onto the conductors, or a material of the type adapted to be wrapped onto the conductors. Once the material has been applied to the conductors to form the flexible outer jacket, the heat sensitive cable may be stored on spools due to its flexibility and later may be removed and cut to length for use as needed.

According to another aspect of this invention, there is provided a method of manufacturing a heat sensitive cable as defined in claim 15.

With the manufacturing method of the invention, a heat sensitive cable is provided which may be utilized not only to monitor ambient temperature but also to monitor for any localised increase above ambient temperature.

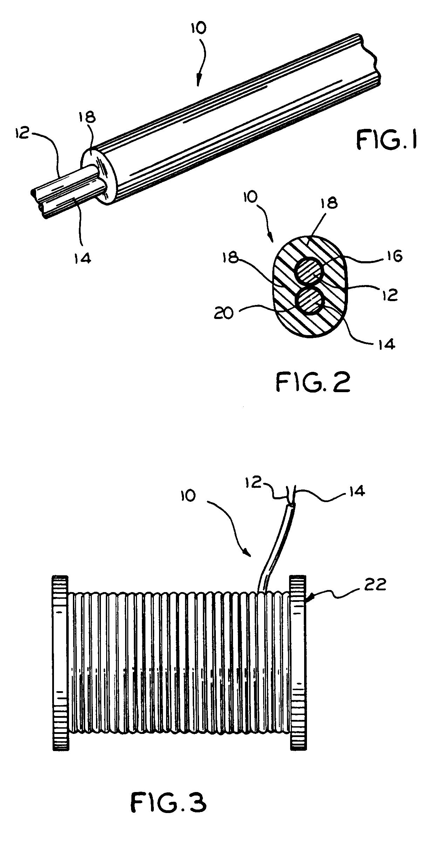

This invention will now be described in more detail, by way of example, with reference to the drawings in which:
Figure 1 is a perspective view of a section of heat sensitive cable in accordance with the present invention;
Figure 2 is a cross-sectional view of the cable illustrated in Figure 1;
Figure 3 is an elevational view of a spool containing the cable illustrated in Figure 1;
Figure 4 is a schematic view of a method of manufacturing heat sensitive cable in accordance with the present invention;
Figure 5 is a top plan view taken along the line 5-5 of Figure 4;
Figure 6 is an elevational view of a section of heat sensitive cable manufactured in accordance with the method of Figure 4;
Figure 7 is a cross-sectional view taken along the line 7-7 of Figure 6;
Figure 8 is a schematic view of an alternative method of manufacturing heat sensitive cable in accordance with the present invention;
Figure 9 is a top plan view taken along the line 9-9 of Figure 8;
Figure 10 is an elevational view of a section of heat sensitive cable manufactured in accordance with the method of Figure 8;
Figure 11 is a cross-sectional view taken along the line 11-11 of Figure 10;
Figure 12 is a schematic view of another alternative method of manufacturing heat sensitive cable in accordance with the present invention;
Figure 13 is an elevational view of a section of heat sensitive cable manufactured in accordance with the method of Figure 12;
Figure 14 is a cross-sectional view taken along the line 14-14 of Figure 13; and
Figure 15 is a schematic view of still another alternative method of manufacturing heat sensitive cable in accordance with the present invention;
Referring to the drawings, and first to Figure 1, the reference numeral 10 designates generally a heat sensitive cable capable of generating a temperature representative measurable voltage. The cable 10 includes a pair of thermoelectric conductors 12 and 14 disposed in contacting side-by-side relation together with means for passively self-generating a temperature representative measurable voltage between the conductors 12 and 14 when the cable 10 is exposed to ambient temperature. A flexible outer jacket 18 formed of an electrically non-conductive material is provided to completely surround the conductors 12 and 14. The passive self-generating means includes means for causing a change in the temperature representative measurable voltage with an increase or decrease in temperature at every location along the jacket 18. A change in the temperature representative measurable voltage under such condition is representative of a change in ambient temperature. The passive self-generating means also includes means for causing a change in the temperature representative measurable voltage with an increase in temperature above the prevailing ambient at any location along the jacket 18. With this arrangement, the heat sensitive cable 10 may be utilized not only to monitor ambient temperature but also to monitor for any localised increase in temperature.

The passive self-generating means includes an electrical insulation 16 having a negative temperature coefficient disposed on the surface of at least one of the conductors 12 and 14. Preferably the conductor 12, for instance, is coated with a solution of manganese nitrate or heat treated manganese dioxide on the order of 0.050 to 0.150 mm (0.002 to 0.006 inches) thick. By so doing, the resulting electrical insulation 16 which is formed on the surface of the conductor 12 will provide the required temperature representative measurable voltage throughout the desired range of temperatures.

With regard to the electrical insulation 16, the conductor 12 is provided with a treated surface in one embodiment by coating the conductor 12 with a manganese nitrate solution. After the conductor 12 has been coated with the solution, which is preferably approximately 61 percent manganese nitrate, the conductor is heated to a temperature of between 150° and 230°C (300° and 450°F) to complete the surface treatment process whereby the conductor 12 has an electrical insulation 16 with a negative temperature coefficient. Moreover, as shown in Figure 1, the conductor 14 also preferably has an electrical insulation 20 having a negative temperature coefficient provided by a like surface treatment process.

In practice, it has been found advantageous to provide the solution of manganese nitrate by heating manganese nitrate at a temperature of approximately 38°C (100°F). The manganese nitrate is heated at this temperature until melted and thereafter the melted manganese nitrate is heated at between approximately 205° and 260°C (400° and 500°F) for approximately 3 minutes. With this procedure, the manganese nitrate is first reduced from a solid to a thin liquid and is then converted from a thin liquid to a thick, black substance.

Referring to Figure 2, it will be appreciated that the elements comprising the heat sensitive cable 10 have been exaggerated in size to enhance the illustration. The electrical insulation 16 on the conductor 12 and the electrical insulation 20 on the conductor 14 both comprise very thin surface coatings which are sufficient to permit the conductors 12 and 14 to be disposed in contacting side-by-side relation, but separated and electrically insulated by the thin coatings of electrical insulation 16 and 20 . By reason of the intimate electrically insulated contact of conductors 12 and 14, the heat sensitive cable 10 may be utilized to monitor temperature as indicated in a completely satisfactory manner.

In the embodiment illustrated in Figure 2, the conductors 12 and 14 disposed in contacting side-side-side relation are formed of thermoelectrically dissimilar materials, eg, one of the conductors 12 is preferably formed of a nickel/chromium alloy and the other of the conductors 14 is preferably formed of a copper/nickel alloy. It will be appreciated, however, that all of the embodiments illustrated in the drawings need only be formed of thermoelectrically dissimilar materials, eg, those commonly known as ANSI K, E, J, or T thermoelectric pairs, or any other conductors formed of thermoelectrically dissimilar materials. Nevertheless, when nickel/chromium and copper/nickel alloys are selected, it has been found advantageous for the nickel/chromium alloy to comprise approximately 90 percent nickel and 10 percent chromium and the copper/nickel alloy to comprise approximately 55 percent copper and 45 percent nickel.

Considering the flexible outer jacket 18, it may be formed of any of a number of electrically non-conductive materials with the desired flexibility characteristics. It is contemplated that the outer jacket 18 may be formed, for instance, of a material adapted to be extruded onto the conductors 12 and 14, or of a material adapted to be heat shrunk on the conductors 12 and 14, or of a material adapted to be wrapped onto the conductors 12 and 14. Regardless of the method of applying the material to the conductors 12 and 14, it is only necessary that the material hold the conductors 12 and 14 together under some pressure in contacting side-by-side relation and be sufficiently flexible to permit the cable to be wound on a spool 22, as shown in Figure 3.

With respect to the method of manufacturing the cable, a pair of thermoelectric conductors is initially provided. Next, means are provided for passively self-generating a temperature representative measurable voltage between the conductors when the cable is exposed to ambient temperature. The conductors are then positioned so as to be disposed in contacting side-by-side relation. Finally, a flexible outer jacket formed of an electrically non-conductive material is applied to the conductors so that the conductors are completely surrounded by the jacket. The passive self-generating means is selected so as to include means for causing a change in the temperature representative measurable voltage with an increase or decrease in temperature at every location along the jacket. A change in the temperature representative measurable voltage under such condition is representative of a change in the ambient temperature. The passive self-generating means is also selected so as to include means for causing a change in the temperature representative measurable voltage with an increase in temperature above the prevailing ambient at any location along the jacket. With the manufacturing method of the invention, a heat sensitive cable is provided which may be utilised not only to monitor ambient temperature but also to monitor for any localised increase above ambient temperature.

As previously mentioned, the surface of the conductor is treated by coating the conductor with a manganese nitrate solution. It is preferable for the solution to comprise approximately 61 percent manganese nitrate. After the conductor has been coated, it is heated to a temperature of between 150° and 230°C (300° and 450°F) to provide an electrical insulation having a negative temperature coefficient.

While the invention is not to be construed as limited to any specific components, one practical embodiment utilises either extruded or heat shrinkable rubber for the flexible outer jacket 18. In this embodiment, one of the two conductors 12 is 14 gauge Chromel (registered trade mark) brand wire of Hoskins Manufacturing Co, Detroit, Michigan, and the other of the conductors 14 is 24 gauge Constantan (registered trade mark) brand wire available from the same company, where both of the wires have been subjected to a surface treatment process in which they have first been abrasively cleaned and then coated with a chemical, such as a manganese nitrate solution, which when heated and applied under controlled conditions results in a permanent change in the electrical resistivity of the outside surface of the wires. Specifically, the two wires are treated by dipping or otherwise coating them in a solution of 61 percent manganese nitrate and then subjecting them to temperatures of 150° to 205°C (300° to 400°F) for a short period of time in the range of approximately 3 to 5 minutes.

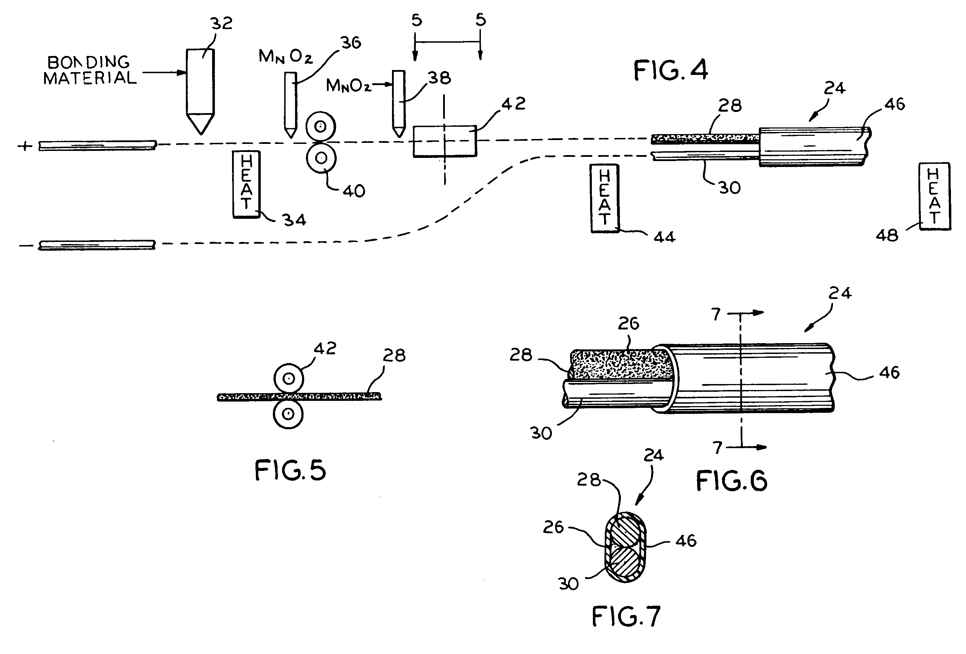

Referring now to Figures 4 to 7, an alternative embodiment of the present invention is illustrated. The heat sensitive cable 24 is preferably identical to the heat sensitive cable 10 with a single exception, ie, the electrical insulation 26 provided on the surface of at least one of the conductors 28 and 30. As shown, the electrical insulation 26 is comprised of a powder embedded in a bonding material.

As illustrated, the surface of the conductor 28 is provided by coating the conductor 28 with a bonding material as at 32. Heat is applied to the conductor 28 as at 34 (and/or prior to application of the bonding material) and the powdered electrical insulation is applied as at 36 and 38. As will be seen, the powdered electrical insulation as at 36 and 38 is embedded in the bonding material 32 by means of rollers at 40 and 42, respectively. Heat is then applied as at 44 after the powdered electrical insulation has been embedded in the bonding material. Finally, the conductors 28 and 30 are inserted into a flexible outer jacket 46, which is preferably made of heat shrinkable material, after which heat is applied as at 48 to shrink the flexible outer jacket 46 thereby forcing the conductors 28 and 30 into intimate contact with one another.

As for the bonding material, any material capable of use within the desired temperature limits can be utilised. For instance, clear silicone rubber caulk manufactured by General Electric Company is suitable as the bonding material for many applications because it is unaffected by temperatures ranging from -55° and 260°C (-65° and 500°F), and it is also possible to use a conductive adhesive such as Amicon CT--5047-2, C-840, or C-950 sold by the Polymer Products Division of Amicon Corporation. When a conductive adhesive is used, it is possible to provide a heavier coating on the conductors than silicone will normally permit.

With regard to the powdered electrical insulation, it is preferably heat treated manganese dioxide following the teachings in US-A-4,491,822, US-A-4,540,972 and US-A-4,614,024. With this material, the insulation has an insulation resistance of between approximately 3,000 and 6,000 Ohms at approximately 22°C (72°F) which has been found sufficient to produce a negative temperature coefficient insulator operable over a wide temperature range.

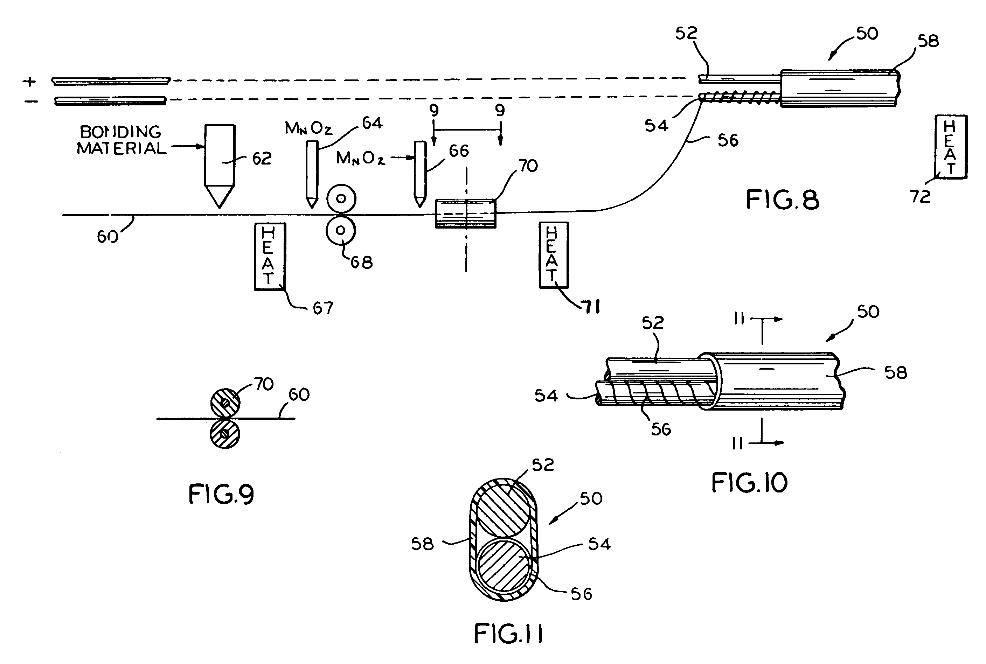

Referring now to Figures 8 to 11, another alternative embodiment of the present invention is illustrated. The heat sensitive cable 50 is comprised of thermoelectrically dissimilar conductors 52 and 54, and electrical insulation as at 56 applied on the surface of at least one of the conductors 54, and a flexible outer jacket 58. As shown, the electrical insulation as at 56 is applied in a unique fashion.

In particular, the surface of the conductor 54 is provided with an electrical insulation by utilizing a flexible wrap material 60. The flexible wrap material 60, which can be any flexible material but preferably one that is absorbent, is covered with a bonding material as at 62 and the bonding material is embedded with a powdered electrical insulation as at 64 and 66. Thereafter, the conductor 54 is wrapped with the flexible wrap material 60.

Once again, the bonding material as at 62 is preferably a temperature resistant adhesive and the powdered electrical insulation as at 64 and 66 is preferably heat treated manganese dioxide. The flexible wrap material 60 may be heated before and/or after application of the bonding material as at 67, it is then rolled as at 68 and 70 immediately after application of the powdered electrical insulation as at 64 and 66, respectively, and heat is applied subsequent to rolling as at 71. After the flexible wrap material 60 has been prepared it is then wrapped about the conductor 54, the conductors 52 and 54 are inserted in a flexible outer jacket 58 of heat shrinkable material, and heat is applied as at 72.

As shown in Figure 10, the electrical insulation 56 need not totally cover the outer surface of the conductor 54. It is only necessary that the treated flexible wrap material 60 comprising the electrical insulation 56 be wrapped sufficiently close together to maintain the surfaces of the conductors 52 and 54 out of contact with one another. As long as this condition is met, the cable 50 will function in the intended fashion.

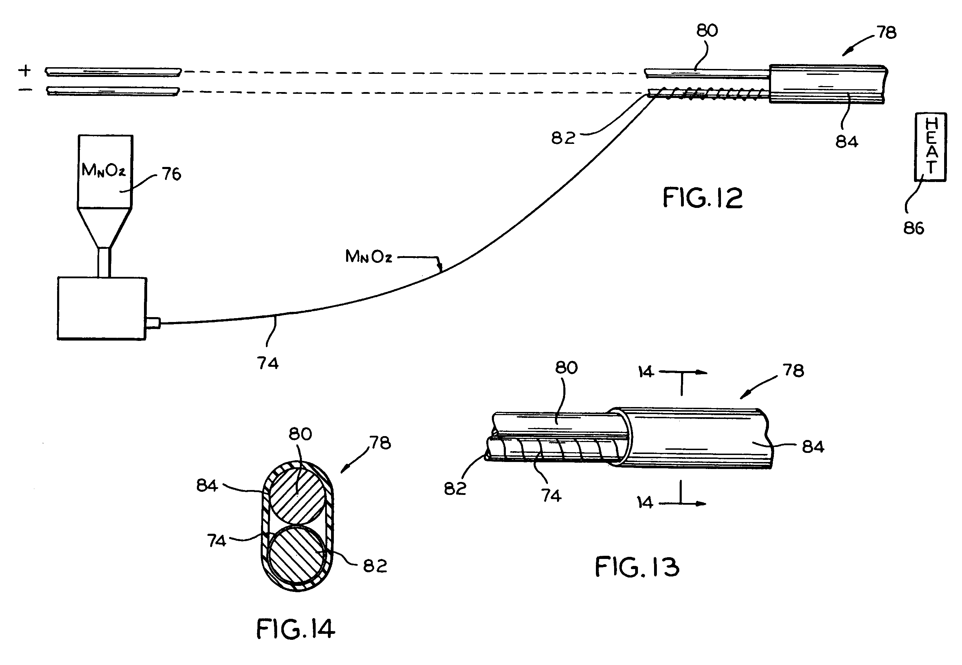

Referring now to Figures 12 to 14, still another alternative embodiment of the present invention is illustrated. This embodiment is similar to the embodiment discussed in connection with Figures 8 to 11, but differs in that the flexible wrap material which is treated with bonding material and heat treated manganese dioxide in Figure 8 has been replaced by a wire 74 formed of heat treated manganese dioxide as at 76. In other respects, the cable 78 is essentially the same as the cable 50 in Figures 8 to 11.

In particular, the cable 78 is comprised of a pair of thermoelectrically dissimilar conductors 80 and 82. The wire 74, which may be manufactured in accordance with any desired technique, eg, the continuous casting method disclosed in US-A-3,881,541, is then wrapped about the conductor 82, the conductors 80 and 82 are inserted into a flexible outer jacket 84 of heat shrinkable material, and heat is applied as at 86 to complete the manufacturing process. When this has been done, the cable 78 will function in like fashion to the cable 50 in Figures 8 to 11.

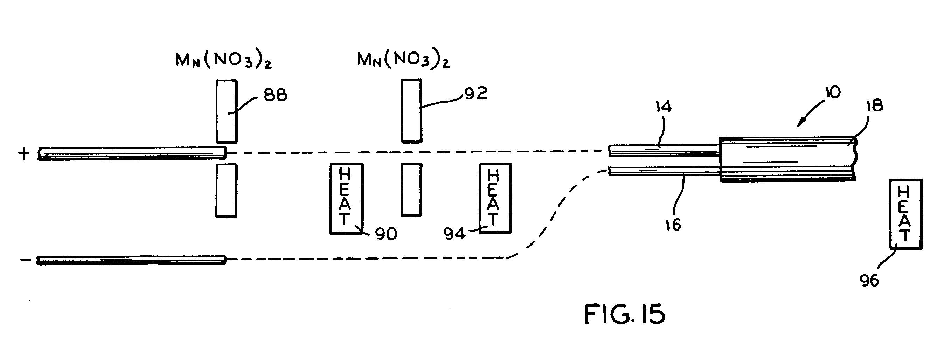

Finally, Figure 15 illustrates one method of manufacturing the heat sensitive cable 10 discussed in connection with Figures 1 to 3. It will be seen that the cable 10 can be formed by applying the manganese nitrate solution (prepared as previously discussed) to at least one of the conductors 14 of the pair of thermoelectrically dissimilar conductors 14 and 16, and this can be done by sponging heat on the manganese nitrate solution as at 88, then applying heat as at 90, and again sponging on manganese nitrate solution as at 92, and then applying heat as at 94, and these steps, ie, sponging on manganese nitrate solution and thereafter heating, can be used once, twice, or as many times as desired to build up a coating of the desired thickness in assembly line fashion. When the coating has been applied to the conductor 14, the conductors 14 and 16 are inserted into the flexible outer jacket 18 of heat shrinkable material and heat is applied as at 96 to force the conductors 14 and 16 to intimate contact.

Still referring to Figure 15, it will be observed that the positive conductor 14 is larger in diameter than the negative conductor 16. This is done to facilitate wiring the cable to suitable monitoring equipment by assuring that even untrained personnel will be able to visually identify the positive conductor and thereafter attach it to the positive terminal of the equipment and in like fashion identify the negative conductor and attach it to the negative terminal, particularly when it is considered that the positive and negative conductors will usually be the same colour. When it is considered that the size of the conductors can be as small as approximately 0.305 mm (0.012 inches), the advantage of providing a visibly larger diameter positive conductor will be apparent.

With regard to coating the surface of one or both conductors with an electrical insulation, the sole criteria is to apply a coating that remains ductile. In other words, the coating is provided with a thickness wherein the cable is capable of being bent around a small diameter, eg one and a quarter to two and a half centimetres (one-half to one inch) in diameter without cracking or otherwise impairing the surface coating of electrical insulation. Depending on the diameter of the conductors, the coating will be thicker or thinner to achieve this result.

With the present invention, a heat sensitive cable has been provided which is capable of generating a measurable voltage when exposed to a temperature of, eg, 22°C (72°F). The voltage measured is representative of that temperature (ambient) and the thermoelectric output of the cable or a section thereof when exposed to a higher temperature will generate a voltage representative of the higher temperature. Moreover, the heat sensitive cable is capable of generating a measurable and predictable voltage as the ambient to which the entire length is exposed is raised above or reduced below 22°C (72°F), eg, a temperature between around -30°C and 260°C (-20° and 500°F) or higher depending upon the limitations of the materials being used. The voltage measured is representative of that temperature (a new ambient) and the thermoelectric output of the cable or a section thereof when exposed to a higher temperature would again generate voltage representative of the higher temperature. Therefore, the heat sensitive cable may be utilised not only to monitor ambient temperature but also to monitor for any localised increase above ambient temperature, and the exact location along the cable where any localised increase occurs can be located electronically.

As previously mentioned, the conductors include chemically treated surfaces, preferably treated with a solution of manganese nitrate, to provide a permanent insulation having a high negative temperature coefficient. The thermoelectric conductors when placed in contacting side-by-side relation along their entire axial length and held firmly together by means of the flexible outer jacket over their entire axial length, as required for a specific application or measurement, will generate a voltage representative of the highest temperature along the length of the cable. Additionally, the cable may be provided with a continuous metallic sheath for certain applications in accordance with the teachings of US-A-3,737,997.

As will be appreciated, the heat sensitive cable of the present invention will constantly generate a measurable voltage. This voltage is usable with conventional, inexpensive pyrometers, analog meters, digital readout indicators, strip chart recorders, temperature controllers and transmitters, state of the art microprocessor based data loggers, calculating data loggers, programmable controllers, etc. Further, with the use of conventional time domain reflectometers and electronic circuitry, the exact location along the cable where the maximum temperature exists may be located.

While all of the embodiments illustrated in the drawings utilise a pair of conductors, it will be appreciated that one or more additional conductors may also be provided. Such an additional conductor, whether insulated or non-insulated, may be useful, for instance, where a bridge network type of location device will be used. Accordingly, the present invention is to be construed as requiring a minimum of two thermoelectric conductors.

With the present invention, an inexpensive product has been provided which may be easily installed by inexperienced persons utilising the same conventional means as used in modern home construction and wiring. The cable is also reusable (within the limits of the cable materials) and effectively provides a continuous temperature sensor. Moreover, the present invention results in the formation of a permanent, flexible, exterior surface insulation condition with a high negative temperature coefficient.

Finally, it is possible to provide an essentially continuous heat sensitive cable, ie, the cable can be produced in lengths of thousands of metres (feet), at a fraction of the cost of making conventional types of constructions of heat sensitive devices or cables.

With the present invention, the heat sensitive cable provides a thermocouple temperature monitoring device which consists of a pair of conductors having surfaces treated with an electrical insulation having a negative temperature coefficient within a flexible outer jacket. The cable is passive and self-generating to generate a voltage potential between the thermoelectric conductors which is indicative of the temperature existing along its entire length, or if the temperatures are unequal, at the hottest point along the cable length when subjected to external temperatures. When monitored by a high input impedance temperature device, the heat sensitive cable is capable of (1) precise, nonperishable, reproducible measurement of the temperature and (2) identification of the location of the hottest spot, and is capable of utilising varying combinations of materials to yield various mechanical properties and temperature-voltage response curves.

## Claims

1. A heat sensitive cable (10) comprising a pair of conducting wires (12, 14) made of thermoelectrically dissimilar materials, disposed in a side by side relationship and contacting through a semiconductor material and held together by an outer jacket (18)
characterized in that
(a) the outer jacket is flexible and made of an electrically non-conductive material
(b) at least one of the conducting wires has been treated with the semiconductor material which has been applied thereto in the form of a thin, ductile surface coating (16, 20) or wrap (56, 74), so that said conductors are spaced apart throughout their length only by virtue of the thickness of said surface coating or wrap.

2. The heat sensitive cable as defined by Claim 1, characterised in that said semiconductor material (16, 20) on said wire is a coating of a manganese nitrate solution.

3. The heat sensitive cable as defined by Claim 1, characterised in that said semiconductor material (26; 56) on said wire is a coating of a bonding material embedded with a powdered semiconductor.

4. The heat sensitive cable as defined by Claim 3, characterised in that said bonding material is a temperature resistant adhesive and said powdered semiconductor is heat treated manganese dioxide.

5. The heat sensitive cable as defined by Claim 1, characterised in that said semiconductor material (56) on said surface of said conductor is a flexible wrap material covered with a bonding material embedded with a powdered semiconductor wrapped on said conductor.

6. The heat sensitive cable as defined by Claim 5, characterised in that said bonding material is a temperature resistant adhesive and said powdered semiconductor is heat treated manganese dioxide.

7. The heat sensitive cable as defined by Claim 1, characterised in that said semiconductor material (74) on said surface of said conductor is a wire having a negative temperature coefficient wrapped on said conductor.

8. The heat sensitive cable as defined by Claim 7, characterised in that said wire is formed of heat treated manganese dioxide.

9. The heat sensitive cable as defined by Claim 1, characterised in that one of said conductors (12) is formed of a nickel/chromium alloy and the other of said conductors (14) is formed of a copper/nickel alloy.

10. The heat sensitive cable as defined by Claim 9, characterised in that said nickel/chromium alloy comprises approximately 90 percent nickel and 10 percent chromium and said copper/nickel alloy comprises approximately 55 percent copper and 45 percent nickel.

11. The heat sensitive cable as defined by Claim 1, characterised in that said flexible outer jacket (18) is formed of an extruded material and holds said conductors together under pressure along their entire length.

12. The heat sensitive cable as defined by Claim 1, characterised in that said flexible outer jacket (18; 46; 58; 84) is formed of a heat shrink material and holds said conductors together under pressure along their entire length.

13. The heat sensitive cable as defined by Claim 1, characterised in that said flexible outer jacket (18) is formed of a wrapping material and holds said conducting wires together under pressure along their entire length.

14. The heat sensitive cable as defined by Claim 1, characterised in that the heat sensitive cable is operable in a predictable fashion over a range of temperatures of between around at least -30° and 260°C (-20° and 500°F).

15. A method of manufacturing the heat sensitive cable of claim 1, comprising the steps of
(a) providing a pair of conducting wires (12, 14) made of thermoelectrically dissimilar materials
(b) applying semiconductor material to at least one of the wires in the form of a thin, ductile surface coating (16, 20) or in the form of a wrap(56, 74)
(c) disposing the wires in a side by side relationship
(d) surrounding the wires by a flexible outer jacket (18) formed of an electrically non-conductive material, so that said conducting wires are spaced apart throughout their length only by virtue of the thickness of said surface coating or wrap.

16. The method of manufacturing a heat sensitive cable as defined by Claim 15, characterised in that the step of applying said semiconductor material includes coating said conductor (12,14) with a manganese nitrate solution.

17. The method of manufacturing a heat sensitive cable as defined by Claim 16, characterised in that said manganese nitrate solution is provided by heating manganese nitrate at a temperature of approximately 38°C (100°F) until melted and thereafter heating said melted manganese nitrate at between approximately 205° and 260°C (400° and 500°F) for approximately three minutes.

18. The method of manufacturing a heat sensitive cable as defined by Claim 16, characterised in that said semiconductor material applying step includes heating said conductor after coating with said manganese nitrate solution.

19. The method of manufacturing a heat sensitive cable as defined by Claim 18, characterised in that said conductor is coated with a solution of approximately 61 percent manganese nitrate and said conductor is heated to a temperature of between 150° and 230°C (300° and 450°F).

20. The method of manufacturing a heat sensitive cable as defined by Claim 15, characterised in that said semiconductor material applying step includes coating said conductor (28) with a bonding material and embedding said bonding material with a powdered semiconductor.

21. The method of manufacturing a heat sensitive cable as defined by Claim 20, characterised in that said semiconductor material applying step includes heating said conductor after covering said conductor with said bonding material, said bonding material thereafter being embedded with said powdered semiconductor.

22. The method of manufacturing a heat sensitive cable as defined by Claim 21, characterised in that said semiconductor material applying step includes heating said conductor after said bonding material has been embedded with said powdered semiconductor.

23. The method of manufacturing a heat sensitive cable as defined by Claim 22, characterised in that said bonding material is a temperature resistant adhesive and said powdered semiconductor is heat treated manganese dioxide.

24. The method of manufacturing a heat sensitive cable as defined by Claim 15, characterised in that said semiconductor material applying step includes providing a flexible wrap material (60), covering said flexible wrap material (60) with a bonding material, embedding said bonding material with a powdered semiconductor, and wrapping said conductor (54) with said flexible wrap material.

25. The method of manufacturing a heat sensitive cable as defined by Claim 24, characterised in that said bonding material is a temperature resistant adhesive and said powdered semiconductor is heat treated manganese dioxide.

26. The method of manufacturing a heat sensitive cable as defined by Claim 15, characterised in that said semiconductor material applying step includes providing a wire (74) having a negative temperature coefficient and wrapping said conductor (82) with said wire.

27. The method of manufacturing a heat sensitive cable as defined by Claim 26, characterised in that said wire is formed of heat treated manganese dioxide.

28. The method of manufacturing a heat sensitive cable as defined by Claim 15, characterised in that one of said conductors (12) is a nickel/chromium alloy and the other of said conductors (14) is a copper/nickel alloy.

29. The method of manufacturing a heat sensitive cable as defined by Claim 28, characterised in that said nickel/chromium alloy comprises approximately 90 percent nickel and 10 percent chromium and said copper/nickel alloy comprises approximately 55 percent copper and 45 percent nickel.

30. The method of manufacturing a heat sensitive cable as defined by Claim 15, characterised in that said flexible outer jacket (18) is applied by extruding an electrically non-conductive material onto said conductors to hold said conductors together under pressure along their entire length.

31. The method of manufacturing a heat sensitive cable as defined by Claim 15, characterised in that said flexible outer jacket (18; 46; 58; 84) is applied by heat shrinking an electrically non-conductive material onto said conductors to hold said conductors together under pressure along their entire length.

32. The method of manufacturing a heat sensitive cable as defined by Claim 15, characterised in that said flexible outer jacket (18) is applied by wrapping an electrically non-conductive material onto said conductors to hold said conductors together under pressure along their entire length.

33. The method of manufacturing a heat sensitive cable as defined by Claim 15, characterised in that the heat sensitive cable is operable in a predictable fashion over a range of temperatures of between around at least -30° and 260°C (-20° and 500°F)

## Patentansprüche

1. Ein wärmeempfindliches Kabel (10), das ein Paar von leitenden Drähten (12, 14) enthält, die aus thermoelektrisch verschiedenen Materialien gemacht sind, die Seite-an-Seite angeordnet und sich durch ein Halbleitermaterial kontaktieren und durch eine äußere Umhüllung (18) zusammengehalten sind, **dadurch gekennzeichnet,** daß
a) die äußere Umhüllung biegsam ist und aus einem elektrisch nicht-leitenden Material gemacht ist,
b) wenigstens einer der leitenden Drähte mit einem Halbleitermaterial behandelt wurde, welches darauf in der Form einer dünnen, verformbaren Oberflächenbeschichtung (16, 20) oder Hülle (56, 74) aufgetragen wird, so daß die Leiter über ihre ganze Länge nur aufgrund der Dicke der Oberflächenbeschichtung oder Hülle beabstandet sind.

2. Ein wärmeempfindliches Kabel nach Anspruch 1, dadurch gekennzeichnet, daß das Halbleitermaterial (16, 20) auf dem Draht eine Beschichtung aus einer Mangangnitrat-Lösung ist.

3. Das wärmeempfindliche Kabel nach Anspruch 1, dadurch gekennzeichnet, daß das Halbleitermaterial (26, 56) auf dem Draht eine Beschichtung aus einem Bindemittel, in das ein pulverisierter Halbleiter eingebettet ist, ist.

4. Das wärmeempfindliche Kabel nach Anspruch 3, dadurch gekennzeichnet, daß das Bindemittel ein temperaturbeständiger Klebstoff und der pulverisierte Halbleiter ein wärmebehandeltes Mangandioxid ist.

5. Das wärmeempfindliche Kabel nach Anspruch 1, dadurch gekennzeichnet, daß das Halbleitermaterial (56) auf der Oberfläche des Leiters ein biegsames Hüllenmaterial ist, das mit einem Bindemittel bedeckt ist, in dem ein pulverisierter Halbleiter eingebettet ist, und das den Leiter umhüllt.

6. Das wärmeempfindliche Kabel nach Anspruch 5, dadurch gekennzeichnet, daß das Bindemittel ein temperaturbeständiger Klebstoff und der pulverisierte Halbleiter ein wärmebehandeltes Mangandioxid ist.

7. Das wärmeempfindliche Kabel nach Anspruch 1, dadurch gekennzeichnet, daß das Halbleitermaterial (74) auf der Oberfläche des Leiters ein Draht ist, der einen negativen Temperaturkoeffizienten aufweist und um den Leiter gewickelt ist.

8. Das wärmeempfindliche Kabel nach Anspruch 7, dadurch gekennzeichnet, daß der Draht aus wärmebehandeltem Mangandioxid gebildet ist.

9. Das wärmeempfindliche Kabel nach Anspruch 1, dadurch gekennzeichnet, daß einer der Leiter (12) aus einer Nickel/Chrom-Legierung und der andere der Leiter (14) aus einer Kupfer/Nickel-Legierung gebildet ist.

10. Das wärmeempfindliche Kabel nach Anspruch 9, dadurch gekennzeichnet, daß die Nickel/Chrom-Legierung ungefähr 90% Nickel und 10% Chrom enthält, und daß die Kupfer/Nickel-Legierung ungefähr 55% Kupfer und 45% Nickel enthält.

11. Das wärmeempfindliche Kabel nach Anspruch 1, dadurch gekennzeichnet, daß die biegsame äußere Umhüllung (18) aus extrudiertem Material hergestellt ist und die Leiter über ihre gesamte Länge unter Druck zusammenhält.

12. Das wärmeempfindliche Kabel nach Anspruch 1, dadurch gekennzeichnet, daß die biegsame äußere Umhüllung (18; 46; 58; 84) aus einem wärmeschrumpfbaren Material hergestellt ist und die Leiter über ihre gesamte Länge unter Druck zusammenhält.

13. Das wärmeempfindliche Kabel nach Anspruch 1, dadurch gekennzeichnet, daß die biegsame äußere Umhüllung (18) aus einem Hüllenmaterial hergestellt ist und die leitenden Drähte über ihre gesamte Länge unter Druck zusammenhält.

14. Das wärmeempfindliche Kabel nach Anspruch 1, dadurch gekennzeichnet, daß das wärmeempfindliche Kabel in einer vorhersagbaren Art und Weise wenigstens in einen Temperaturbereich zwischen ungefähr -30° und 260°C (-20° und 500°F) einsetzbar ist.

15. Ein Verfahren zur Herstellung des wärmeempfindlichen Kabels nach Anspruch 1, das folgende Schritte enthält:
a) Das Bereitstellen eines Paars von leitenden Drähten (12, 14), die aus thermoelektrisch verschiedenen Materialien gemacht sind,
b) das Auftragen von Halbleitermaterial auf wenigstens einen der Drähte in Form einer dünnen, verformbaren Oberflächenbeschichtung (16, 20) oder in der Form einer Hülle (56, 74),
c) das Anordnen der Drähte Seite-an-Seite,
d) das Umgeben der Drähte durch eine biegsame äußere Umhüllung (18), die aus einem elektrisch nichtleitendem Material hergestellt ist, so daß die leitenden Drähte über ihre gesamte Länge nur aufgrund der Dicke der Oberflächenbeschichtung oder der Hülle beabstandet sind.

16. Das Verfahren zur Herstellung eines wärmeempfindlichen Kabels nach Anspruch 15, dadurch gekennzeichnet, daß der Schritt des Auftragens des Halbleitermaterials eine Beschichtung der Leiter (12, 14) mit einer Mangannitrat-Lösung enthält.

17. Das Verfahren zur Herstellung eines wärmeempfindlichen Kabels nach Anspruch 16, dadurch gekennzeichnet, daß die Mangannitrat-Lösung durch ein Erwärmen von Mangannitrat auf eine Temperatur von ungefähr 38°C (100°F) bis es schmilzt und danach ein Erwärmen des geschmolzenen Mangannitrats auf ungefähr 205° bis 260°C (400° bis 500°F) für ungefähr drei Minuten bereitgestellt wird.

18. Das Verfahren zur Herstellung eines wärmeempfindlichen Kabels nach Anspruch 16, dadurch gekennzeichnet, daß der Schritt des Aufbringens des Halbleitermaterials ein Erwärmen des Leiters nach der Beschichtung mit der Mangannitrat-Lösung enthält.

19. Das Verfahren zur Herstellung eines wärmeempfindlichen Kabels nach Anspruch 18, dadurch gekennzeichnet, daß der Leiter mit einer Lösung aus ungefähr 61% Mangannitrat beschichtet wird, und daß der Leiter auf eine Temperatur zwischen 150° und 230°C (300° und 450°F) erwärmt wird.

20. Das Verfahren zur Herstellung eines wärmeempfindlichen Kabels nach Anspruch 15, dadurch gekennzeichnet, daß der Schritt des Auftragens des Halbleitermaterials ein Beschichten des Leiters (28) mit einem Bindemittel und ein Einbetten eines pulverisierten Halbleiters in das Bindemittel enthält.

21. Das Verfahren zur Herstellung eines wärmeempfindlichen Kabels nach Anspruch 20, dadurch gekennzeichnet, daß der Schritt des Auftragens des Halbleitermaterials ein Erwärmen des Leiters nach dem Beschichten des Leiters mit dem Bindemittel enthält, wobei danach in das Bindemittel der pulverisierte Halbleiter eingebettet wird.

22. Das Verfahren zur Herstellung eines wärmeempfindlichen Kabels nach Anspruch 21, dadurch gekennzeichnet, daß der Schritt des Auftragens des Halbleitermaterials ein Erwärmen des Leiters enthält, nachdem in das Bindemittel der pulverisierte Halbleiter eingebettet wurde.

23. Das Verfahren zur Herstellung eines wärmeempfindlichen Kabels nach Anspruch 22, dadurch gekennzeichnet, daß das Bindemittel ein temperaturbeständiger Klebstoff und der pulverisierte Halbleiter ein wärmebehandeltes Mangandioxid ist.

24. Das Verfahren zur Herstellung eines wärmeempfindlichen Kabels nach Anspruch 15, dadurch gekennzeichnet, daß der Schritt des Auftragens des Halbleitermaterials das Bereitstellen eines biegsamen Hüllenmaterials (60), das Beschichten des biegsamen Hüllenmaterials (60) mit einem Bindemittel, das Einbetten eines pulverisierten Halbleiters in das Bindemittel und das Umhüllen des Leiters (54) mit dem biegsamen Hüllenmaterial enthält.

25. Das Verfahren zur Herstellung eines wärmeempfindlichen Kabels nach Anspruch 24, dadurch gekennzeichnet, daß das Bindemittel ein temperaturbeständiger Klebstoff und der pulverisierte Halbleiter ein wärmebehandeltes Mangandioxid ist.

26. Das Verfahren zur Herstellung eines wärmeempfindlichen Kabels nach Anspruch 15, dadurch gekennzeichnet, daß der Schritt des Auftragens des Halbleitermaterials das Bereitstellen eines Drahts (74), der einen negativen Temperaturkoeffizient aufweist, und das Umwickeln des Leiters (82) mit dem Draht enthält.

27. Das Verfahren zur Herstellung eines wärmeempfindlichen Kabels nach Anspruch 26, dadurch gekennzeichnet, daß der Draht aus wärmebehandeltem Mangandioxid hergestellt ist.

28. Verfahren zur Herstellung eines wärmeempfindlichen Kabels nach Anspruch 15, dadurch gekennzeichnet, daß einer der Leiter (12) aus einer Nickel/Chrom-Legierung und der andere der Leiter (14) aus einer Kupfer/Nickel-Legierung besteht.

29. Das Verfahren zur Herstellung eines wärmeempfindlichen Kabels nach Anspruch 28, dadurch gekennzeichnet, daß die Nickel/Chrom-Legierung ungefähr 90% Nickel und 10% Chrom und die Kupfer/Nickel-Legierung ungefähr 55% Kupfer und 45% Nickel enthält.

30. Das Verfahren zur Herstellung eines wärmeempfindlichen Kabels nach Anspruch 15, dadurch gekennzeichnet, daß die biegsame äußere Hülle (18) auf die Leiter durch ein Extrudieren eines elektrisch nicht-leitenden Materials aufgebracht wird, um die Leiter über ihre gesamte Länge unter Druck zusammenzuhalten.

31. Das Verfahren zur Herstellung eines wärmeempfindlichen Kabels nach Anspruch 15, dadurch gekennzeichnet, daß die biegsame äußere Umhüllung (18; 46; 58; 84) durch ein Wärmeschrumpfen eines elektrisch nicht-leitenden Materials auf die Leiter aufgebracht wird, um die Leiter über ihre gesamte Länge unter Druck zusammenzuhalten.

32. Das Verfahren zur Herstellung eines wärmeempfindlichen Kabels nach Anspruch 15, dadurch gekennzeichnet, daß die biegsame äußere Umhüllung (18) durch ein Umhüllen der Leiter mit einem elektrisch nicht-leitenden Material aufgebracht wird, um die Leiter über ihre gesamte Länge unter Druck zusammenzuhalten.

33. Das Verfahren zur Herstellung eines wärmeempfindlichen Kabels nach Anspruch 15, dadurch gekennzeichnet, daß das wärmeempfindliche Kabel in einer vorhersagbaren Art und Weise über einen Temperaturbereich zwischen ungefähr wenigstens -30° und 260°C (-20° und 500°F) einsetzbar ist.

## Revendications

1. Câble thermosensible (10) comportant une paire de fils conducteurs (12,14) en matériaux différents du point de vue thermoélectrique, disposés côte à côte et en contact par l'intermédiaire d'un matériau semiconducteur et maintenus ensemble par une enveloppe extérieure (18), caractérisé en ce que :
(a) l'enveloppe extérieure est souple et faite d'un matériau électriquement non-conducteur,
(b) au moins l'un des fils conducteurs a été traité avec le matériau semiconducteur qu'on a appliqué sur ce fil sous forme d'un revêtement superficiel mince et ductile (16,20) ou d'une gaine (56,74), de telle manière que lesdits conducteurs sont séparés l'un de l'autre sur toute leur longueur du seul fait de l'épaisseur dudit revêtement ou gainage.

2. Câble thermosensible selon la revendication 1, caractérisé en ce que ledit matériau semiconducteur (16,20) appliqué sur ledit fil est un enduit d'une solution de nitrate de manganèse.

3. Câble thermosensible selon la revendication 1, caractérisé en ce que ledit matériau semiconducteur (26 ; 56) appliqué sur ledit fil est un revêtement à base d'un liant chargé d'une poudre de matériau semiconducteur.

4. Câble thermosensible selon la revendication 3, caractérisé en ce que ledit liant est un adhésif résistant à la chaleur, et en ce que ladite poudre de matériau semiconducteur est constituée de dioxyde de manganèse traité à chaud.

5. Câble thermosensible selon la revendication 1, caractérisé en ce que ledit matériau semiconducteur (56) appliqué sur ladite surface dudit conducteur est constitué par un matériau de gainage souple recouvert d'un liant chargé d'une poudre de matériau semiconducteur, et dans lequel on a enveloppé ledit conducteur.

6. Câble thermosensible selon la revendication 5, caractérisé en ce que ladite couche de liant est à base d'un adhésif résistant à la chaleur, ladite poudre de matériau semiconducteur étant constituée de dioxyde de manganèse traité à chaud.

7. Câble thermosensible selon la revendication 1, caractérisé en ce que ledit matériau semiconducteur (74) appliqué sur ladite surface dudit conducteur est constitué par un fil à coefficient de température négatif et dans lequel on a enveloppé ledit conducteur.

8. Câble thermosensible selon la revendication 7, caractérisé en ce que le fil appliqué sur ledit conducteur est constitué de dioxyde de manganèse traité à chaud.

9. Câble thermosensible selon la revendication 1, caractérisé en ce que l'un desdits conducteurs (12) est en alliage de nickel/chrome et l'autre desdits conducteurs (14) est en alliage de cuivre/nickel.

10. Câble thermosensible selon la revendication 9, caractérisé en ce que ledit alliage de nickel/chrome comporte approximativement 90% de nickel et 10% de chrome, et ledit alliage de cuivre/nickel comporte approximativement 55% de cuivre et 45% de nickel.

11. Câble thermosensible selon la revendication 1, caractérisé en ce que ladite enveloppe extérieure (18) est en un matériau extrudé qui maintient ensemble lesdits conducteurs sous pression sur toute leur longueur.

12. Câble thermosensible selon la revendication 1, caractérisé en ce que ladite enveloppe souple extérieure (18; 46 ; 58 ; 84) est constituée d'un matériau qui se rétracte sous l'effet de la chaleur et maintient ensemble lesdits conducteurs sous pression sur toute leur longueur.

13. Câble thermosensible selon la revendication 1, caractérisé en ce que ladite enveloppe souple extérieure (18) est constituée par un matériau de gainage qui maintient ensemble lesdits fils conducteurs sous pression sur toute leur longueur.

14. Câble thermosensible selon la revendication 1, caractérisé en ce que ce câble thermosensible est utilisable de manière prévisible sur une plage de températures comprises entre au moins -30°C et 260°C environ (-20°F à 500°F).

15. Procédé pour fabriquer un câble thermosensible conforme à la revendication 1, comportant les phases suivantes :
(a) on prend un paire de fils conducteurs (12,14) dans des matériaux différents quant à leurs propriétés thermoélectriques,
(b) on applique un matériau semiconducteur sur au moins l'un des fils sous la forme d'un revêtement superficiel mince et ductible (16, 20) ou sous la forme d'une gaine (56, 74),
(c) on dispose les fils côte à côte,
(d) on entoure les fils par une enveloppe extérieure souple (18) en matériau électriquement non-conducteur, de telle manière que lesdits fils se trouvent séparés l'un de l'autre sur toute leur longueur du seul fait de l'épaisseur du revêtement superficiel ou de la gaine unitaire.

16. Procédé pour fabriquer un câble thermosensible, selon la revendication 15, caractérisé en ce que la phase d'application dudit matériau semiconducteur comprend l'enduction dudit conducteur (12,14) par une solution de nitrate de manganèse.

17. Procédé pour fabriquer un câble thermosensible, selon la revendication 16, caractérisé en ce qu'on obtient ladite solution de nitrate de manganèse en chauffant du nitrate de manganèse à une température d'environ 38° C (100°F) jusqu'à fusion, et en chauffant ensuite ledit nitrate de manganèse fondu à une température comprise entre 205°C et 260°C environ (400°F à 500°F) pendant trois minutes environ.

18. Procédé pour fabriquer un câble thermosensible, selon la revendication 16, caractérisé en ce que ladite phase d'application du matériau semiconducteur comporte le chauffage dudit conducteur après enduction avec ladite solution de nitrate de manganèse.

19. Procédé pour fabriquer un câble thermosensible, selon la revendication 18, caractérisé en ce qu'on applique sur ledit conducteur un revêtement constitué par une solution qui comporte approximativement 61% de nitrate de manganèse, et en ce qu'on chauffe ledit conducteur à une température comprise entre 150°C et 230°C (300°F à 450°F) .

20. Procédé pour fabriquer un câble thermosensible, selon la revendication 15, caractérisé en ce que la phase d'application dudit matériau semiconducteur comporte l'enduction dudit conducteur (28) par un liant, ledit liant étant ensuite enrobé avec ladite poudre de matériau semiconducteur.

21. Procédé pour fabriquer un câble thermosensible, selon la revendication 20, caractérisé en ce que la phase d'application dudit matériau semiconducteur comporte le chauffage dudit conducteur, après enduction avec ledit liant, ledit liant étant ensuite enrobé avec ladite poudre de matériau semiconducteur.

22. Procédé pour fabriquer un câble thermosensible, selon la revendication 21, caractérisé en ce que la phase d'application dudit matériau semiconducteur comporte le chauffage dudit conducteur, après que ledit liant a été enrobé avec ladite poudre de matériau semiconducteur.

23. Procédé pour fabriquer un câble thermosensible, selon la revendication 22, caractérisé en ce que ledit liant est un adhésif résistant à la température, et ledit matériau semiconducteur en poudre est du dioxyde de manganèse traité à chaud.

24. Procédé pour fabriquer un câble thermosensible, selon la revendication 15, caractérisé en ce que la phase d'application dudit matériau semiconducteur comporte l'utilisation d'un matériau de gainage souple (60), l'application d'un liant sur ledit matériau de gainage souple (60), l'enrobage dudit liant avec un matériau semiconducteur en poudre et le gainage dudit conducteur (54) avec ledit matériau de gainage souple.

25. Procédé pour fabriquer un câble thermosensible, selon la revendication 24, caractérisé en ce que ledit liant est un adhésif résistant à la température, et ledit matériau semiconducteur en poudre est du dioxyde de manganèse traité à chaud.

26. Procédé pour fabriquer un câble thermosensible, selon la revendication 15, caractérisé en ce que la phase d'application dudit matériau semiconducteur comporte l'utilisation d'un fil (74) ayant un coefficient de température négatif, et l'enroulement dudit fil autour dudit conducteur (82) .

27. Procédé pour fabriquer un câble thermosensible, selon la revendication 26, caractérisé en ce que ledit fil est constitué de dioxyde de manganèse traité à chaud.

28. Procédé pour fabriquer un câble semiconducteur, selon la revendication 15, caractérisé en ce que l'un desdits conducteurs (12) est en alliage de nickel/chrome, et l'autre desdits conducteurs (14) est en alliage de cuivre/nickel.

29. Procédé pour fabriquer un câble semiconducteur, selon la revendication 28, caractérisé en ce que ledit alliage de nickel/chrome comporte approximativement 90% de nickel et 10% de chrome, et ledit alliage de cuivre/nickel comporte environ 55% de cuivre et 45% de nickel.

30. Procédé pour fabriquer un câble thermosensible, selon la revendication 15, caractérisé en ce qu'on applique ladite enveloppe extérieure souple (18) en extrudant un matériau électriquement non-conducteur sur lesdits conducteurs, pour maintenir ensemble lesdits conducteurs sous pression sur toute leur longueur.

31. Procédé pour fabriquer un câble thermosensible, selon la revendication 15, caractérisé en ce que ladite enveloppe extérieure souple (18 ; 46 ; 58 ; 84) est appliquée par thermo-rétraction d'un matériau électriquement non-conducteur sur lesdits conducteurs à traiter, pour maintenir ensemble lesdits conducteurs sous pression sur toute leur longueur.

32. Procédé pour fabriquer un câble thermosensible, selon la revendication 15, caractérisé en ce que ladite enveloppe extérieure souple (18) est appliquée en enveloppant lesdits conducteurs avec une matériau électriquement non-conducteur, pour maintenir ensemble lesdits conducteurs sous pression sur toute leur longueur.

33. Procédé pour fabriquer un câble thermosensible, selon la revendication 15, caractérisé en ce que ce câble thermosensible est utilisable de manière prévisible dans une plage de température allant au moins de -30°C à 260°C environ (-20°F à 500°F).
